# EUROPEAN PATENT SPECIFICATION

(11) **EP 3 399 551 B1**
(45) Date of publication and mention of the grant of the patent: **13.04.2022**
(21) Application number: 16874087.6
(22) Date of filing: 11.11.2016
(51) Int. Cl.: H01L 51/56, H01L 27/32, H01L 27/12

(54) **METHOD FOR PREPARING OLED DISPLAY DEVICE**
VERFAHREN ZUR HERSTELLUNG EINER OLED-ANZEIGEVORRICHTUNG
PROCÉDÉ DE PRÉPARATION D'UN DISPOSITIF D'AFFICHAGE À DELO

(30) Priority: 31.12.2015 CN 201511030805
(43) Date of publication of application: 07.11.2018
(73) Proprietor: BOE Technology Group Co., Ltd., Beijing 100015 (CN)
(72) Inventor: WANG, Xiyuan, Beijing 100176 (CN); PENG, Yuqing, Beijing 100176 (CN); ZI, Yubao, Beijing 100176 (CN)
(74) Representative: Potter Clarkson
(86) International application number: PCT/CN2016/105458
(87) International publication number: WO 2017/114000

(56) References cited:
- CN-A- 1 372 319
- CN-A- 1 925 138
- CN-A- 101 047 207
- CN-A- 105 428 373
- KR-A- 20120 035 785
- US-A1- 2007 194 303
- US-A1- 2015 303 220
- US-A1- 2015 333 112

## Description

### TECHNICAL FIELD

The present invention relates to the field of OLED display production, and particularly to a method for producing an OLED display device.

### BACKGROUND ART

In the production of an OLED display device such as a display panel, a method of forming respective functional elements (such as layered functional elements, also referred to as functional layers) on a substrate is typically used. A common substrate is glass, etc. For example, an organic electroluminescent thin film and a cathode metal thin film are formed by evaporating on a glass substrate, so as to form an OLED display device. When the size of the substrate is relatively large, for example, in the production of an OLED television display (for example, G6: 1.5 m×1.85 m; G8.5: 2.2 m×2.5 m), a conveying system is required to be used in a production line, in order to overcome bending of the substrate caused by the gravity action itself.

Because an electrostatic adsorption type conveying system generates an electrostatic field having a relatively high intensity which damages thin film transistors, a non-electrostatic-adsorption type conveying system comprising an adhesive pad and a base is typically used. Particularly, a glass substrate may be adhered to a surface of a base by using an adhesive pad and then is conveyed and transported, for example.

However, after the completion of the evaporation process, a pin separation action (an action of pushing up using pins) is typically required to separate the substrate from the base. That is, the substrate is jacked-up at certain points by using pins and separated from the base. The pin separation action may cause damage to the thin film transistor at the element side of the substrate. Finally, when the produced display panel is lit, mura in display may be generated, such mura is referred to as pin mura.

In order to solve the problem of mura in display caused by the pin separation operation, some methods have been developed. For example, the position of pins may be arranged outside active area of a display panel. However, in the manner of eliminating mura by shifting pins out from the active area of the display panel, the location of the pin is fixed, as a result, the production line cannot be applied for all products having various sizes (it can be applied only for a few of products having certain sizes). Furthermore, it fails to eliminate electrostatic damage in the area in contact with the pin. If this area corresponds to a fan-out area, it may result in badness; and if it is outside the panel, the area of substrate is wasted.

US2015/303220 A1 discloses a first insulating substrate (glass substrate) and a conductive film formed on substantially the entirety of the first main surface of the first insulating substrate wherein the potential at the first main surface can be maintained evenly regardless of pin holes. KR20120035785 A discloses a substrate separation module and apparatus provided to independently control expansion pressure of a diaphragm for each section, thereby uniformly separating a substrate from a tray regardless of properties of an adhesive member. US2015/333112 A1 discloses that even if electrostatic energy is generated in the manufacturing process of an organic EL device, a conductive film contacting the mother substrate diffuses the electrostatic energy and therefore electrostatic energy is not charged locally on the mother substrate. US2007/194303 A1 discloses an organic light-emitting element that prevents the deterioration of a driving circuit incorporated in an organic light-emitting element substrate due to static electricity from an electrostatic chuck, comprising holding the organic light-emitting element substrate with the electrostatic chuck and bonding it to a sealing substrate.

Therefore, in the production of an OLED display device, a technical means is still required to overcome the problem of mura in a finished product in the production process of a large-size substrate.

### SUMMARY OF THE INVENTION

According to an aspect of the invention, there is provided a method for producing an OLED display device according to claim 1.

### BRIEF DESCRIPTION OF DRAWINGS

Fig. 1 is a sectional view of one embodiment of a laminated substrate falling outside of the scope of this invention.
Fig. 2 is a sectional view showing one embodiment of a display device falling outside of the scope of this invention.
Fig. 3 is a schematic diagram of a pin separation process.
Fig. 4 shows a schematic diagram of relative positions of the base, the pins, and the display device.
Fig. 5 shows that there is no phenomenon of mura after a display panel produced using a laminated substrate having an IZO conductive layer is lit, manufactured according to one embodiment of this invention.
Fig. 6 shows mura after a display panel produced using a pin separation process in the prior art is lit.

### DESCRIPTION OF EMBODIMENTS

In one aspect of this application, before the process of pin separation, a laminated substrate is previously formed by providing a conductive layer on a surface (i.e. bottom surface) of a substrate to be in contact with pins. Thus, upon pin separation, this conductive layer may conduct static electricity timely and may also be used as a stress buffering layer for reducing local extrusion stress, so that it is possible to effectively eliminate mura caused by pins and improve display quality and yield rate of the product. Furthermore, since it is not required to exclusively set the position of pins, the production line may be applied for all products having various sizes.

Herein, the term "bottom surface" refers to a surface of a substrate on which no functional element is formed. As a substrate for OLED, it has the function of supporting respective functional elements, such as an electroluminescent element, and therefore respective functional elements are all formed on the same side of the substrate. Herein, a surface of the substrate which does not support functional elements is referred to as the bottom surface, so as to distinguish the laminated substrate of this disclosure from a substrate irrespective of this disclosure where a conductive layer is formed on the functional element surface.

In some embodiments, the conductive layer is transparent. Particularly, when the substrate is a substrate of a bottom-emission device, light is transmitted through the substrate, and thus the conductive layer is required to be transparent. Of course, if the substrate is a substrate of a top-emission device, it may be transparent, or it may be not transparent.

In some embodiments, the substrate may be glass. The glass substrate is the most widely used substrate in the art, and is particularly suitable for a base-pin conveying system.

In some embodiments, the conductive layer is a metal oxide conductive thin film, an organic conductive thin film, carbon nanotube, graphene, a metal grid, metal nanowire, an ultrathin metal thin film, etc. Typically, as long as the conductive layer is conductive, it serves to eliminate point discharging. The above-described kinds of conductive layers may simultaneously meet the requirements for conduction and extrusion reduction, and are those more studied and used in the art. The production process is more mature, and it is possible to achieve the technical effect without performing much more improvement on the production line and without more increasing the cost.

In some specific embodiments, the metal oxide conductive thin film may be an ITO (indium tin oxide), IZO (indium zinc oxide), IGZO (indium gallium zinc oxide), or ZnO (zinc oxide) thin film. These thin films are transparent conductive oxides (TCO), which have both conductivity and transparency, and mechanical properties thereof are also suitable to be used as mechanical buffering layers. In an organic conductive thin film, PEDOT (polyethylenedioxythiophene) is preferable.

In some embodiments, the conductive layer has a thickness of 0.1 nanometers to 10 micrometers. When it is less than 0.1 nanometers, the ability of the conductive layer to conduct electricity is insufficient. When it is more than 10 micrometers, too much material is consumed and the time of production is long, so it is disadvantageous in terms of cost. Also, when the conductive layer is a transparent layer, if the thickness is more than 10 micrometers, the transparency of the conductive layer is insufficient. The thickness range may be preferably 10 nanometers to 1 micrometer. When it is in a range less than 10 nanometers, the ability to alleviate extrusion is poor.

In this disclosure, a particularly preferable laminated substrate is one in which glass is used as a substrate and ITO, IZO, IGZO, ZnO, PEDOT, a metal grid, carbon nanotube (CNT), graphene, metal nanowire, or an ultrathin metal thin film is used as a conductive layer. The conductive layer has a thickness of 10 nanometers to 1 micrometer.

An aspect of this application provides a method for producing an OLED display device, which comprises using the laminated substrate of this disclosure.

Particularly, a surface having a conductive layer is brought into contact with an equipment configuration (or a conveying system) in the production, so as to eliminate influences of static electricity and extrusion. Functional elements and the like are formed on a surface having no conductive layer.

The conductive layer of the laminated substrate may be located at a light emergent side of the OLED device, or may be located at a side opposite to the light emergent side. When it is located at the light emergent side, the conductive layer must be transparent; and when it is located at the side opposite to the light emergent side, the conductive layer may be transparent or may be not transparent.

The laminated substrate of the method of this invention is used in a pin separation mechanism. In embodiments falling outside of the scope of the invention, it may also be used to be in contact with another equipment configuration, such as a sucker, a roller, and the like, and may serve to release static electricity and buffer partial extrusion stress. The production method of this application is used for a process flow of production including a pin separation process.

According to the invention, the conductive layer of the laminated substrate is downward and faces to the base conveying system for conveying the substrate, and is placed on an adhesive pad of the base; and after the substrate are conveyed and respective functional elements are formed, the laminated substrate is jacked-up under the action of pins at the conductive layer side to allow the separation of the laminated substrate and the base.

According to the invention, the OLED display device is produced by the steps of: forming a part of functional elements of the OLED display device on a side of the substrate; forming the laminated substrate of this application by providing a conductive layer on a side of the substrate having no functional elements formed; placing the conductive layer side of the laminated substrate on the base conveying system; forming the remaining part (including an organic electroluminescent thin film and a cathode metal thin film) of the functional elements of the OLED display device on the functional element side of the laminated substrate; and jacking-up the laminated substrate at the conductive layer side by means of pins to allow the separation of the laminated substrate and the base.

An aspect of this disclosure not falling within the scope of the invention provides a display device comprising the laminated substrate of this disclosure, the display device may include a laminated substrate on one side or both sides thereof.

The laminated substrate of the present disclosure is particularly suitable for the production of large-size displays, but is not limited thereto. In the manufacture process of middle- and small-size OLED display devices, such as cell phone screens, laptop screens, monitor screens, and tablet computer screens, the laminated substrate of this application may also be used.

The manufacture process of the laminated substrate is simple, and it may solve the aforementioned point discharging and stress concentration problems by only adding a conductive layer without any additional process. The conductive layer is not limited to be produced by means of sputtering, and may also be produced by means of thermal evaporation, electron beam evaporation, ink jetting, roll-to-roll transfer printing, spin coating, etc.

The method of this application may be used in the manufacture process of back panels, including α-Si back panels, oxide semiconductor back panels, low-temperature polysilicon (LTPS) back panels, etc.

For a display panel produced by using the laminated substrate of this disclosure, it is possible to effectively eliminate mura generated by pins, which is proved by experiments.

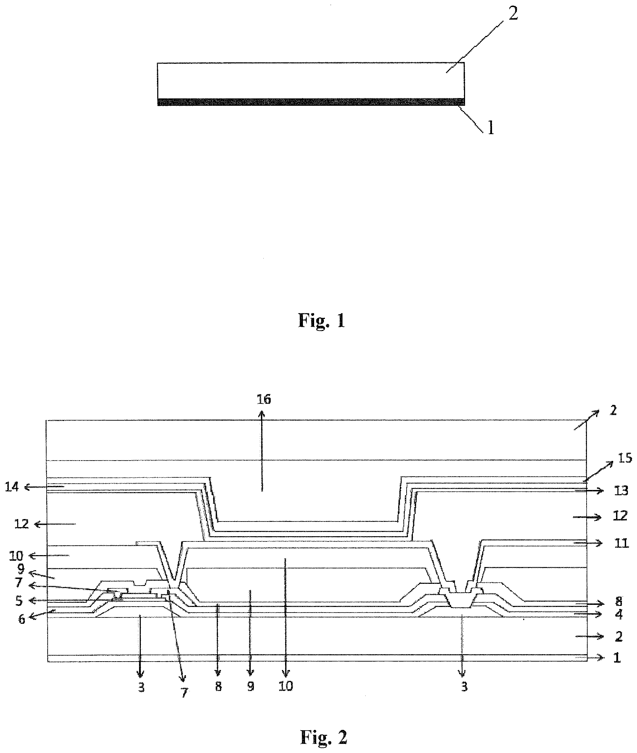

Fig. 1 shows a sectional view of one embodiment of a laminated substrate not falling within the scope of the invention.

The laminated substrate is composed of a conductive layer 1 and a substrate 2. In the case as shown in Fig. 1, functional elements are all formed on the top of the laminated substrate. Furthermore, although the conductive layer 1 is typically in a form of thin film, it may also be in a form of, for example, a metal grid.

Particularly, by the following steps, the display panel as shown in Fig. 2 can be produced:
(1) performing initial cleaning on bare glass, depositing a gate metal (a metal such as Mo/Al/Mo or Cu, etc.) in a sputtering manner, exposing, developing, etching, and peeling;
(2) depositing a SiO₂ or SiNx film as a gate insulating layer by CVD (chemical vapor deposition);
(3) depositing an IGZO film as an active layer in a sputtering manner (for an α-Si back panel, an α-Si film is deposited by CVD; and for a LTPS back panel, an α-Si film is deposited by CVD, and then an ELA process is performed), exposing, developing, etching, and peeling;
(4) depositing a SiO₂ or SiNx film as an insulating layer by CVD, followed by exposing, developing, etching, and peeling to form a S/D CNT Hole (a connecting hole);
(5) depositing a S/D metal (Mo/Al) in a sputtering manner, exposing, developing, etching, and peeling;
(6) depositing a SiO₂ or SiNx film as a PVX (passivation layer) by CVD, followed by exposing, developing, etching, and peeling to form a via hole;
(7) coating a CF adhesive, baking, exposing, and developing to form an RGB color filter;
(8) coating a resin adhesive, baking, exposing, and developing to form a white color filter;
(9) depositing an ITO film in a sputtering manner, exposing, developing, etching, and peeling to form a transparent conductive anode;
(10) coating a PDL (pixel defining layer) adhesive, baking, exposing, turning the glass over, depositing a transparent conductive oxide (TCO) film (ITO, IZO, IGZO, ZnO, and the like may be selected) having a certain thickness on the back side of the glass in a sputtering manner, turning the glass over, developing, and heat-curing to form a laminated substrate; and fixing the conductive layer side of the laminated substrate on the base conveying system by an adhesive pad;
(11) performing high-vacuum deposition of an organic electroluminescent film and high-vacuum deposition of a cathode metal (A1 or Ag) on the laminated substrate on the base conveying system, and subsequently performing pin separation of the base and glass;
(12) depositing an encapsulating thin film such as SiNx or SiNx/SiCNx/SiNx or the like by CVD;
(13) coating a filler adhesive on a glass cover plate (coating a Dam encapsulating adhesive on panel edges), performing vacuum cell-aligning of the glass cover plate and the glass, and curing by heating; and
(14) cutting to form a panel.

The meanings of symbols in Fig. 2 are as follows: 1. conductive layer, 2. glass, 3. gate metal film, 4. gate insulator (GI) film, 5. active layer film, 6. insulator film, 7. S/D metal film, 8. PVX film, 9. CF adhesive, 10. resin, 11. ITO film, 12. PDL, 13. organic electroluminescent film, 14. cathode metal film, 15. TFE (thin film encapsulation), and 16. filler.

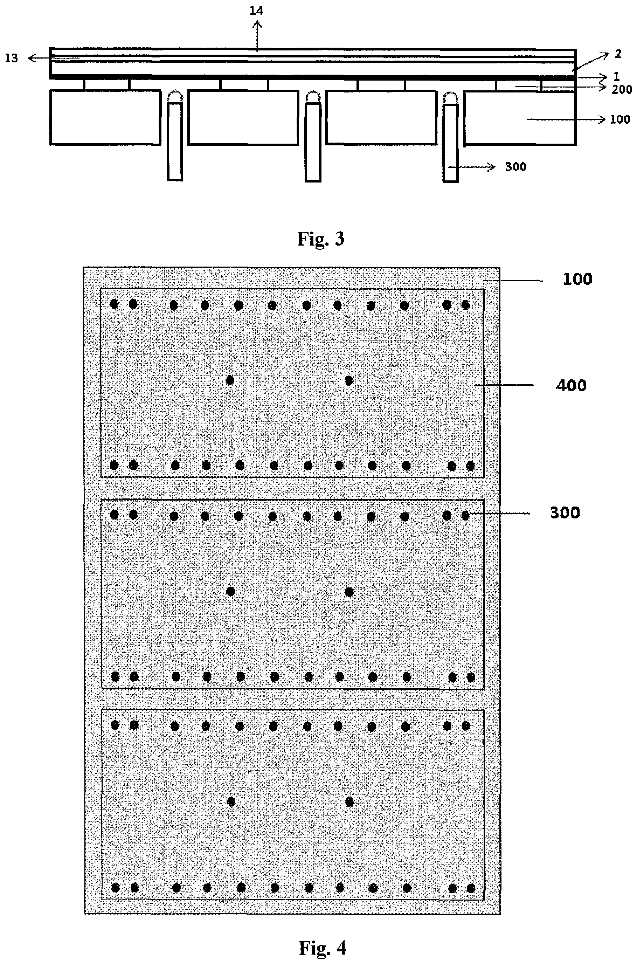

The process of pin separation is as shown in Fig. 3. The pins 300 jack up the laminated substrate which includes the glass substrate 2 and conductive layer 1 and is adhered to a surface of the base 100 via the adhesive pad 200, so as to separate the substrate from the base 100. Note that for the purpose of simplification, only organic electroluminescent film 13 and cathode metal film 14 on the glass substrate 2 are shown in Fig. 3.

Fig. 4 is a schematic diagram showing relative positions of the base 100, the pins 300, and the display device. As seen in Fig. 4, the pins 300 are located in the active area 400 of the display device.

In the process flow described above, the steps for producing a display device are substantially the same as those in existing production methods except that in step (10), the glass substrate is turned over, a conductive layer is deposited by sputtering, and subsequently the glass substrate is turned over again (turned back). Thereafter, high-vacuum deposition of an organic electroluminescent film, high-vacuum deposition of a cathode metal, and subsequent pin separation are performed in step (11).

It should be noted that the laminated substrate of this disclosure is not present in its entirety at the very beginning in the above exemplified production process of a display device. Although the laminated substrate of this disclosure may also be provided at the very beginning, this may result in the problems as follows. First, since a conveying system having a base + pin is not necessary to be used at the early stage in the process of the production of a display device but conveying apparatuses with electrostatic adsorption or a robotic arm are usually used, the problem of pin mura will not be generated and therefore it is not necessary to form a conductive layer. Second, if a conductive layer is formed too early, it may suffer from chemistry or mechanical damage, such as a scratch, when it is subjected to, for example, acid washing or another conveying step. On the one hand, the damage to the conductive layer may cause deterioration or extinction of the conductive function; and on the other hand, when it is used as an outer panel of a display device, the defect such as a scratch and the like is not acceptable. Therefore, if the laminated substrate is provided in its entirety at the very beginning in the production process, it will certainly require the material of the conductive layer to have extremely good chemical stability and mechanical properties (such as hardness, etc.), which limits the selection of the conductive layer material and may increase the cost.

Therefore, the laminated substrate of this disclosure is preferably formed just before the substrate is placed onto a base conveying system. Typically, in process steps of high-vacuum deposition of organic electroluminescent film and high-vacuum deposition of cathode metal, a conveying and separation system of base + pin must be used. The process flow of production described above is an example. The substrate, on which a plurality of layers of functional elements have been already formed, does not become the laminated substrate of this disclosure until step (10). After the laminated substrate of this disclosure is formed in step (10), it is placed into the base conveying system, and steps of high-vacuum deposition of the organic electroluminescent film and high-vacuum deposition of the cathode metal are subsequently performed. After that, the laminated substrate and the base are separated by the action of pin separation.

In the example described above, the conductive layer may be a conductive layer structure which is more studied and used and has a more mature production process, such as a metal oxide conductive thin film, an organic conductive thin film, carbon nanotube, graphene, a metal grid, metal nanowire, an ultrathin metal thin film, or the like. The mechanical properties of all of them may also meet the requirement for extrusion reduction. Therefore, by using the conductive layer described above, it is possible to achieve the technical effect without performing much more improvement on the production line and without more increasing the cost. This is extremely advantageous in practical industrial production.

Here, transparent metal oxide conductive thin films are suitable for producing transparent laminated substrates, and the mechanical properties thereof are also suitable to be used as mechanical buffering layers. In some embodiments, conductive layer is ITO, IZO, IGZO, or ZnO. Organic conductive thin films are also suitable for this application, and PEDOT is used in some embodiments.

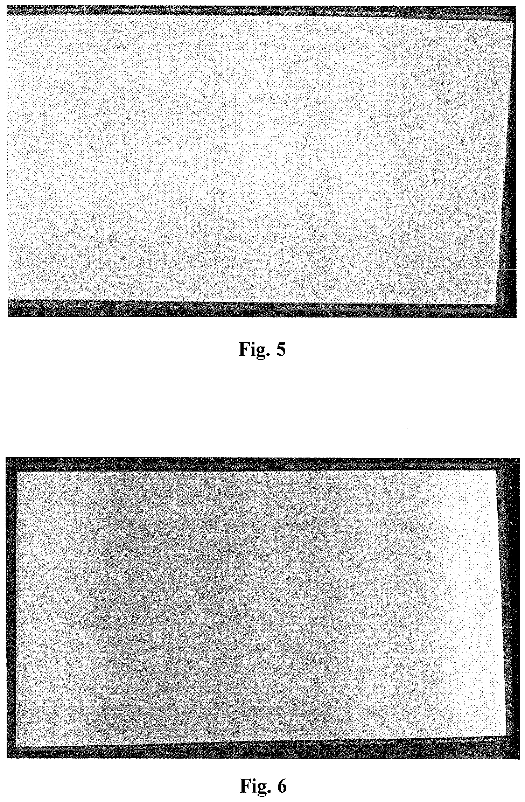

According to repeated experiments, a sufficient ability to conduct electricity may be ensured as long as the thickness of the conductive layer is 0.1 nanometers or more. In order to obtain a better effect of alleviating extrusion simultaneously, the thickness of the conductive layer is preferably 10 nanometers or more. The greater the thickness is, the better the ability to alleviate extrusion is. However, in view of saving the materials consumed and shortening the time of production to reduce the cost and increase the production efficiency, the thickness of the conductive layer is not necessarily more than 10 micrometers. Particularly for a transparent conductive layer, a thickness more than 10 micrometers may have an adverse influence on the transparency thereof. A thickness of 1 micrometer or less is more advantageous. When the thickness of the conductive layer falls in the range described above, as shown in Fig. 5, a white-screen lighting pattern of the display panel produced has a relatively even image. Fig. 6 shows a white-screen lighting pattern of a display panel of the same type in the prior art produced by the same process flow except that the laminated substrate of this application is not formed. The RGBW image exhibits circular dark spots (i.e., pin mura) upon lighting, and it is obvious for low grayscale compared to high grayscale, which severely impacts the quality of the product. As can be seen, this application solves the problems present in the prior art and improves display quality of products.

A particularly preferable laminated substrate is one in which glass is used as a substrate and ITO, IZO, IGZO, ZnO, PEDOT, a metal grid, carbon nanotube, graphene, metal nanowire, or an ultrathin metal thin film is used as a conductive layer. The conductive layer has a thickness of 10 nanometers to 1 micrometer. Fig. 5 is white-screen lighting of the display panel using the laminated substrate of this application. Compared to Fig. 6 in the prior art, it solves the problem of pin mura.

The exemplary method described above is merely for the purpose of illustration, not for limiting this invention. The invention is defined by the appended claims.

## Claims

1. A method for producing an OLED display device, comprising the steps of:
forming a part of functional elements of the OLED display device on a side of a substrate (2);
subsequently forming a laminated substrate (1,2) by providing a conductive layer (1) on a side of the substrate (2) having no functional elements formed thereon, said laminated substrate including the substrate and the conductive layer on bottom surface of the substrate;
subsequently placing the laminated substrate on an adhesive pad of a base conveying system which is used for conveying the laminated substrate, in a manner that the conductive layer (1) of the laminated substrate is face-down and in contact with the adhesive pad
subsequently forming the remaining part of the functional elements of the OLED display device on a side of the laminated substrate having the part of the functional elements formed thereon; and
after the laminated substrate is conveyed and the remaining part of the functional elements are formed, jacking-up the laminated substrate at the conductive layer side by means of pins to allow the separation of the laminated substrate and a base of the base conveying system.

2. The method according to claim 1, wherein the conductive layer (1) is transparent.

3. The method according to claim 1 or 2, wherein the conductive layer (1) is one or more of a metal oxide conductive thin film, an organic conductive thin film, carbon nanotube, graphene, a metal grid, metal nanowire, and an ultrathin metal thin film.

4. The method according to claim 3, wherein the conductive layer (1) is ITO, IZO, IGZO, ZnO, or PEDOT.

5. The method according to any one of claims 1 to 4, wherein the conductive layer (1) has a thickness of 0.1 nanometers to 10 micrometers.

6. The method according to claim 5, wherein the conductive layer (1) has a thickness of 10 nanometers to 1 micrometer.

7. The method according to any one of claims 1 to 6, wherein the substrate (2) ) is glass.

8. The method according to any one of claims 1 to 7, wherein the conductive layer (1) of the laminated substrate is located at a light emergent side of the OLED device or a side opposite to the light emergent side.

9. The method according to claim 1, wherein the remaining part of the functional elements comprises an organic electroluminescent thin film (13) and a cathode metal thin film (14).

10. The method according to any one of claims 1 to 9, wherein the conductive layer (1) is formed by a sputtering process, a thermal evaporation process, an electron beam evaporation process, an ink jetting process, a roll-to-roll transfer printing process, or a spin coating process.

11. The method according to any one of claims 1 to 10, wherein the method is used in the manufacture process of a back panel.

12. The method according to claim 12, wherein the back panel includes an α-Si back panel, an oxide semiconductor back panel, or a low-temperature polysilicon back panel.

## Patentansprüche

1. Verfahren zum Erzeugen einer OLED-Anzeigevorrichtung, das die folgenden Schritte umfasst:
Ausbilden eines Teils von Funktionselementen der OLED-Anzeigevorrichtung auf einer Seite eines Substrats (2);
anschließendes Ausbilden eines laminierten Substrats (1,2) durch Bereitstellen einer leitfähigen Schicht (1) auf einer Seite des Substrats (2), die keine Funktionselemente darauf ausgebildet aufweist, wobei das laminierte Substrat das Substrat und die leitfähige Schicht auf einer unteren Oberfläche des Substrats beinhaltet;
anschließendes Platzieren des laminierten Substrats auf ein Klebepad eines Basistransportsystems, das zum Transportieren des laminierten Substrats auf eine Weise verwendet wird, dass die leitfähige Schicht (1) des laminierten Substrats mit einer Vorderseite nach unten zeigt und mit dem Klebepad in Berührung steht;
anschließendes Ausbilden des verbleibenden Teils der Funktionselemente der OLED-Anzeigevorrichtung auf einer Seite des laminierten Substrats, die den Teil der Funktionselemente darauf ausgebildet aufweist; und
nachdem das laminierte Substrat transportiert wurde und der verbleibende Teil der Funktionselemente ausgebildet wurden, Aufbocken des laminierten Substrats an der Seite der leitfähigen Schicht mittels Stiften, um die Trennung des laminierten Substrats und einer Basis des Basistransportsystems zu ermöglichen.

2. Verfahren nach Anspruch 1, wobei die leitfähige Schicht (1) transparent ist.

3. Verfahren nach Anspruch 1 oder 2, wobei die leitfähige Schicht (1) ein leitfähiger Dünnfilm aus Metalloxid, ein organischer leitfähiger Dünnfilm, ein Kohlenstoffnanoröhrchen, ein Graphen, ein Metallgitter, ein Metallnanodraht und/oder ein ultradünner Metalldünnfilm ist.

4. Verfahren nach Anspruch 3, wobei die leitfähige Schicht (1) ITO, IZO, IGZO, ZnO oder PEDOT ist.

5. Verfahren nach einem der Ansprüche 1 bis 4, wobei die leitfähige Schicht (1) eine Dicke von 0,1 Nanometern bis 10 Mikrometern aufweist.

6. Verfahren nach Anspruch 5, wobei die leitfähige Schicht (1) eine Dicke von 10 Nanometern bis 1 Mikrometer aufweist.

7. Verfahren nach einem der Ansprüche 1 bis 6, wobei das Substrat (2) Glas ist.

8. Verfahren nach einem der Ansprüche 1 bis 7, wobei sich die leitfähige Schicht (1) des laminierten Substrats an einer Lichtaustrittsseite der OLED-Vorrichtung oder einer Seite befindet, die der Lichtaustrittsseite gegenüberliegt.

9. Verfahren nach Anspruch 1, wobei der verbleibende Teil der Funktionselemente einen organischen elektrolumineszierenden Dünnfilm (13) und einen Kathodenmetalldünnfilm (14) umfasst.

10. Verfahren nach einem der Ansprüche 1 bis 9, wobei die leitfähige Schicht (1) durch einen Sputtervorgang, einen thermischen Verdampfungsvorgang, einen Elektronenstrahlverdampfungsvorgang, einen Tintenstrahlvorgang, einen Rolle-zu-Rolle-Transferdruckvorgang oder einen Spin-Coating-Vorgang ausgebildet wird.

11. Verfahren nach einem der Ansprüche 1 bis 10, wobei das Verfahren in dem Herstellungsvorgang einer Rückplatte verwendet wird.

12. Verfahren nach Anspruch 12, wobei die Rückplatte eine α-Si-Rückplatte, eine Oxidhalbleiterrückplatte oder eine Niedertemperatur-Polysiliciumrückplatte beinhaltet.

## Revendications

1. Procédé de fabrication d'un dispositif d'affichage DELO, comprenant les étapes suivantes :
la formation d'une partie d'éléments fonctionnels du dispositif d'affichage DELO sur un côté d'un substrat (2) ;
la formation ensuite d'un substrat stratifié (1, 2) en fournissant une couche conductrice (1) sur un côté du substrat (2) n'ayant aucun élément fonctionnel formé sur celui-ci, ledit substrat stratifié comportant le substrat et la couche conductrice sur la surface inférieure du substrat ;
la placement ensuite du substrat stratifié sur une pastille adhésive d'un système de transport de base qui est utilisé pour transporter le substrat stratifié, de manière à ce que la couche conductrice (1) du substrat stratifié soit face vers le bas et en contact avec la pastille adhésive ;
la formation ensuite de la partie restante des éléments fonctionnels du dispositif d'affichage DELO sur un côté du substrat stratifié ayant la partie des éléments fonctionnels formée sur celui-ci ; et
après que le substrat stratifié est transporté et que la partie restante des éléments fonctionnels est formée, le levage du substrat stratifié du côté de la couche conductrice au moyen de broches afin permettre la séparation du substrat stratifié et d'une base du système de transport de base.

2. Procédé selon la revendication 1, dans lequel la couche conductrice (1) est transparente.

3. Procédé selon la revendication 1 ou 2, dans lequel la couche conductrice (1) est un film fin conducteur d'oxyde métallique et/ou un film fin conducteur organique et/ou un nanotube de carbone et/ou du graphène et/ou une grille métallique et/ou un nanofil métallique et/ou un film fin de métal ultrafin.

4. Procédé selon la revendication 3, dans lequel la couche conductrice (1) est ITO, IZO, IGZO, ZnO ou PEDOT.

5. Procédé selon l'une quelconque des revendications 1 à 4, dans lequel la couche conductrice (1) a une épaisseur de 0,1 nanomètres à 10 micromètres.

6. Procédé selon la revendication 5, dans lequel la couche conductrice (1) a une épaisseur de 10 nanomètres à 1 micromètre.

7. Procédé selon l'une quelconque des revendications 1 à 6, dans lequel le substrat (2) est du verre.

8. Procédé selon l'une quelconque des revendications 1 à 7, dans lequel la couche conductrice (1) du substrat stratifié est située sur un côté émergent de la lumière du dispositif DELO ou sur un côté opposé au côté émergent de la lumière.

9. Procédé selon la revendication 1, dans lequel la partie restante des éléments fonctionnels comprend un film fin électroluminescent organique (13) et un film fin métallique de cathode (14).

10. Procédé selon l'une quelconque des revendications 1 à 9, dans lequel la couche conductrice (1) est formée par un processus de pulvérisation, un processus d'évaporation thermique, un processus d'évaporation par faisceau d'électrons, un processus de projection d'encre, un processus d'impression par transfert rouleau à rouleau, ou un processus de revêtement par rotation.

11. Procédé selon l'une quelconque des revendications 1 à 10, dans lequel le procédé est utilisé dans le processus de fabrication d'un panneau arrière.

12. Procédé selon la revendication 12, dans lequel le panneau arrière comporte un panneau arrière α-Si, un panneau arrière à oxyde semi-conducteur ou un panneau arrière en polysilicium à basse température.
